(19) Europäisches Patentamt
European Patent Office
Office européen des brevets

(11) **EP 4 073 528 B1**

(12) **FASCICULE DE BREVET EUROPEEN**

(45) Date de publication et mention
de la délivrance du brevet:
**28.08.2024 Bulletin 2024/35**

(21) Numéro de dépôt: **20821002.1**

(22) Date de dépôt: **11.12.2020**

(51) Classification Internationale des Brevets (IPC):
**G01R 31/64** (2020.01)

(52) Classification Coopérative des Brevets (CPC):
**G01R 31/64; G01R 31/40**

(86) Numéro de dépôt international:
**PCT/EP2020/085808**

(87) Numéro de publication internationale:
**WO 2021/116436 (17.06.2021 Gazette 2021/24)**

(54) **SURVEILLANCE DU VIEILLISSEMENT D'UN COMPOSANT**

ÜBERWACHUNG DER ALTERUNG EINES BAUTEILS

MONITORING AGING OF A COMPONENT

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **13.12.2019 FR 1914416**

(43) Date de publication de la demande:
**19.10.2022 Bulletin 2022/42**

(73) Titulaires:
• **Commissariat à l'Energie Atomique et aux Energies Alternatives**
  **75015 Paris (FR)**
• **Cefem Industries**
  **07200 Saint Michel de Boulogne (FR)**

(72) Inventeurs:
• **BERGOGNE, Dominique**
  **38054 GRENOBLE CEDEX 9 (FR)**
• **WILLEMIN, Jérôme**
  **38054 GRENOBLE CEDEX 9 (FR)**
• **FANGIER, Jérôme**
  **07200 SAINT MICHEL DE BOULOGNE (FR)**
• **HAMMAL, Redouane**
  **07200 SAINT MICHEL DE BOULOGNE (FR)**
• **FANGIER, Lionel**
  **07200 SAINT MICHEL DE BOULOGNE (FR)**

(74) Mandataire: **Cabinet Beaumont**
  **4, Place Robert Schuman**
  **B.P. 1529**
  **38025 Grenoble Cedex 1 (FR)**

(56) Documents cités:
  **EP-A1- 1 338 874      EP-A1- 3 242 138**
  **EP-B1- 1 338 874      WO-A1-2013/110027**
  **US-A1- 2015 130 380**

## Description

La présente demande de brevet revendique la priorité de la demande de brevet français 19/14416.

### Domaine technique

La présente description concerne de façon générale les systèmes d'évaluation du vieillissement d'un composant ou élément électrique ou d'électronique de puissance. La présente description s'applique plus particulièrement aux systèmes dans lequel des résultats de mesures ou d'évaluations sont transmis à l'extérieur de l'équipement contenant ou auquel est lié le composant dont le vieillissement est évalué.

### Technique antérieure

L'évaluation du vieillissement ou de la durée de vie restante d'un composant électrique ou électronique est largement utilisée dans des équipements de puissance, par exemple des installations de production, de transformation ou de fourniture d'énergie et dans des installations industrielles. Une telle évaluation permet de détecter un besoin de maintenance sur l'équipement ou de remplacement du composant à titre préventif afin d'éviter des pannes.

Une catégorie de composants particulièrement surveillés concerne les condensateurs de puissance. De tels composants se retrouvent dans la plupart des équipements faisant partie d'installations de fourniture, de transport et conversion d'énergie, ou des équipements industriels.

Les techniques connues d'évaluation du vieillissement d'un condensateur utilisent généralement des algorithmes d'estimation de durée de vie basés par exemple sur des mesures de température, de courant et/ou de tension au niveau du condensateur. Des mesures sont effectuées périodiquement au niveau du condensateur et sont transmises à un système distant. Le traitement des mesures est généralement effectué côté système distant, ce qui requiert un volume de données à transmettre relativement important et une consommation d'énergie importante côté condensateur.

Le document WO 2013/110027 décrit des techniques pour déterminer l'état de diodes électroluminescentes et d'alimentation de puissance.

Le document US 2015/130380 décrit un dispositif de commande de moteur.

Le document EP 3 242 138 décrit un procédé pour diagnostiquer l'état d'un condensateur dans un convertisseur modulaire.

Le document EP 1 338 874 décrit un procédé d'estimation de la durée de vie restante, une structure de détection de température et un équipement électronique.

### Résumé de l'invention

Il existe un besoin d'amélioration des systèmes d'évaluation du vieillissement d'un composant afin d'en prédire une éventuelle défaillance.

Il existe un besoin pour des solutions simples et peu gourmandes en énergie, notamment côté équipement, équipé du composant surveillé ou auquel il est lié.

Un mode de réalisation pallie tout ou partie des inconvénients des systèmes connus.

Un mode de réalisation prévoit une solution adaptable à des équipements existants, équipés de composants à surveiller.

Un mode de réalisation prévoit une solution particulièrement adaptée aux condensateurs.

Un mode de réalisation prévoit un circuit de surveillance tel que défini dans la revendication indépendante 1.

Un mode de réalisation prévoit un procédé de surveillance tel que défini dans la revendication indépendante 2.

Selon un mode de réalisation, la valeur représentative de la durée de vie restante est stockée de façon non volatile dans le circuit de surveillance.

Selon un mode de réalisation, ladite valeur représentative de la durée de vie restante est transmise à un système distant, par liaison sans fil.

Selon un mode de réalisation, la fréquence de transmission de ladite valeur représentative de la durée de vie restante est inférieure à la fréquence de calcul de cette valeur.

Selon un mode de réalisation, des mesures courantes des grandeurs physiques sont comparées à des seuils pour déterminer une zone de fonctionnement dans laquelle se trouve le composant.

Selon un mode de réalisation :

des mesures courantes de tension et de températures sont comparées à des seuils pour déterminer une zone de fonctionnement dans laquelle se trouve le condensateur, les zones de fonctionnement correspondant à des zones de l'espace tension/température, avec une zone "centrale" autour d'un couple tension et température nominales, au moins une zone "périphérique" de fonctionnement dégradé du condensateur différente d'une zone de "non-fonctionnement" dans laquelle la tension d'alimentation et la température ne permettent plus au circuit de surveillance de fonctionner ;

la zone de fonctionnement dans laquelle se trouve le condensateur conditionnant le stockage d'un paramètre de façon non volatile dans le circuit de surveillance.

Selon un mode de réalisation, la zone de fonctionnement du composant conditionne la mise en oeuvre du calcul de la valeur représentative de la durée de vie et sons stockage en mémoire non volatile.

Selon un mode de réalisation, dans une zone de fonctionnement, aucune mise à jour de la valeur représentative de la durée de vie restante n'est effectuée.

Selon un mode de réalisation, une zone de fonctionnement conditionne en outre l'émission d'un signal représentatif d'un dysfonctionnement du composant à destination du système distant.

Selon un mode de réalisation, un compteur de durée de vie restante est effacé en le positionnant à zéro.

Selon un mode de réalisation, une zone de vie restante met à zéro le compteur de durée de vie restante.

Selon un mode de réalisation, une alarme est déclenchée et stockée en mémoire, par exemple lorsque la tension nominale est dépassée ou la plage de températures nominales est dépassée.

Selon un mode de réalisation, le calcul de la valeur représentative de la durée de vie restante est effectué à une fréquence comprise entre une seconde et une minute.

Selon un mode de réalisation, le composant est un condensateur.

Selon un mode de réalisation, les grandeurs mesurées sont la tension aux bornes du condensateur et la température du condensateur.

Selon un mode de réalisation, le circuit de surveillance est physiquement intégré au composant lors de la fabrication de ce dernier.

Selon un mode de réalisation, le circuit de surveillance est alimenté directement aux bornes du composant.

Selon un mode de réalisation, le circuit de surveillance utilise au moins deux mesures de température réparties dans ou sur le composant, de sorte à détecter les variations de température susceptibles de se produire de façon localisée en différents points du composant, par exemple en périphérie et au coeur du composant.

Selon un mode de réalisation, la température prise en compte pour le calcul de la durée de vie est égale à la moyenne des températures mesurées par les capteurs de température.

Selon un mode de réalisation, la température prise en compte pour le calcul de la durée de vie est égale à la valeur maximale parmi les températures mesurées par les capteurs de température.

Selon un mode de réalisation, une durée de vie restante nulle ou inférieure à un seuil déclenche l'émission d'un signal.

Un mode de réalisation prévoit un système comportant :

un équipement ;
un composant associé à l'équipement ; et
un circuit de surveillance du fonctionnement du composant tel que divulgué ci-dessus.

Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

la figure 1 représente, de façon très schématique, un mode de réalisation d'un système de surveillance d'un composant ;
la figure 2 représente, de façon très schématique et sous forme de blocs, un mode de réalisation d'un circuit de surveillance d'un composant ;
la figure 3 représente, de façon schématique, un exemple de gabarit de définition de zones de fonctionnement d'un condensateur ;
la figure 4 représente, de façon très schématique et sous forme de blocs, des étapes d'un mode de mise en oeuvre du système de la figure 1 ; et
La figure 5 représente, de façon très schématique, une vue en perspective d'un mode de réalisation d'un composant.

Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, les équipements associés à un ou plusieurs composants surveillés par le système décrit n'ont pas été détaillés, les modes de réalisation décrits étant compatibles avec les équipements usuels. De plus, l'exploitation des informations transmises par le circuit de surveillance décrit n'a pas été détaillée, cette exploitation étant compatible avec les traitements effectués par des systèmes usuels.

Sauf précision contraire, lorsque l'on fait référence à deux éléments connectés entre eux, cela signifie directement connectés sans éléments intermédiaires autres que des conducteurs, et lorsque l'on fait référence à deux éléments reliés ou couplés entre eux, cela signifie que ces deux éléments peuvent être connectés ou être reliés ou couplés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

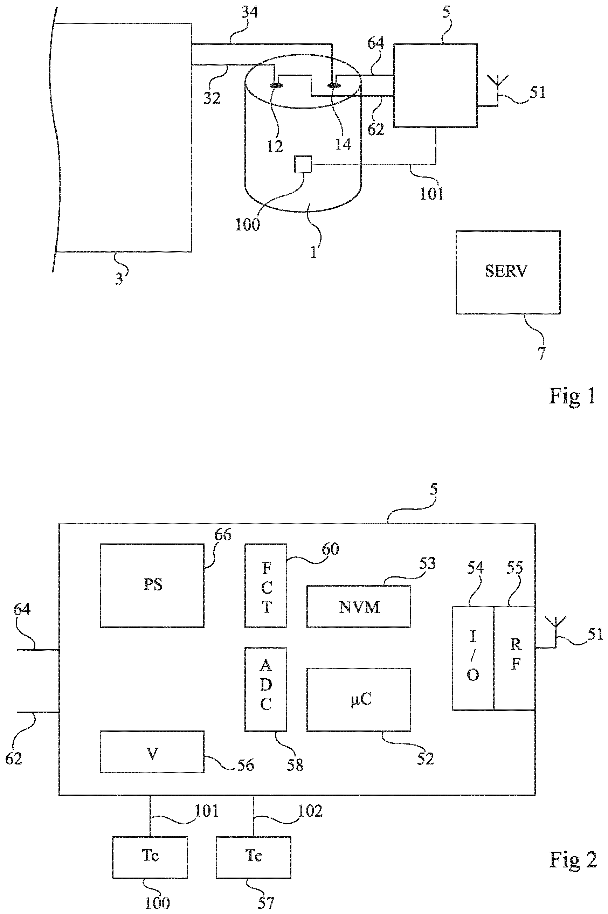

La figure 1 représente, de façon très schématique, un mode de réalisation d'un système de surveillance d'un composant.

Les modes de réalisation décrits s'appliquent plus particulièrement à la surveillance de composants associés à des équipements qui sont eux-mêmes dépourvus de circuits électroniques basse tension de type microcontrôleur, de sorte qu'ils ne disposent pas aisément de capacité de calcul. Par associé ou lié à l'équipement, on entend un composant qui se trouve physiquement lié à l'équipement, embarqué dans celui-ci, fixé à l'équipement ou attaché à celui-ci.

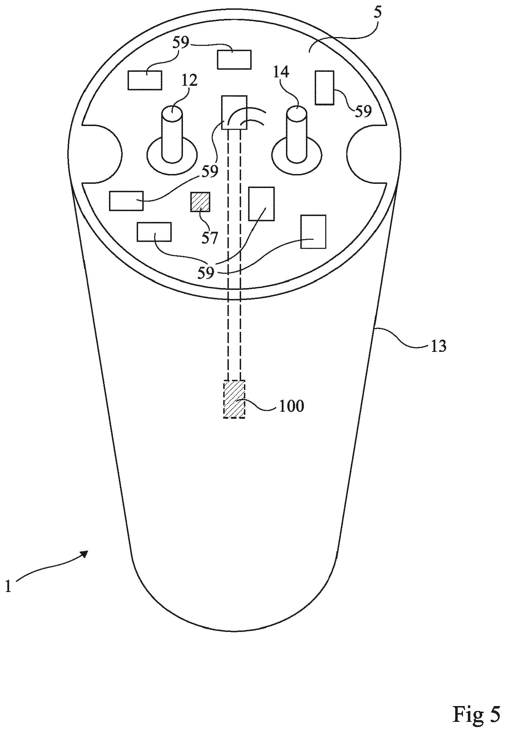

Dans l'exemple représenté, le composant à surveiller est un condensateur 1, par exemple un condensateur de puissance, de type film. Le condensateur 1 équipe un équipement 3 et y est relié par ses deux électrodes 12 et 14 (liaison symbolisée par des fils 32 et 34 reliant l'équipement 3 aux électrodes 12 et 14 du condensateur 1). Le composant 1 comporte préférentiellement d'autres éléments (des éléments d'un circuit de surveillance) associés au condensateur dans un boîtier comme cela est exposé en relation avec la figure 5.

L'équipement est, par exemple, un convertisseur d'énergie (transformateur du réseau de distribution électrique, convertisseur de centrale solaire, etc.), un équipement de puissance d'une centrale de production d'électricité (solaire, thermique, etc.), un équipement industriel (machine-outil, installation de convoyage, etc.), et plus généralement tout type d'équipement utilisant un ou plusieurs condensateurs de puissance.

La surveillance du vieillissement des condensateurs de puissance est particulièrement utile dans la mesure où ils équipent généralement des équipements dans lesquels une défaillance d'un condensateur peut être préjudiciable au fonctionnement, voire à la sécurité de l'installation comprenant l'équipement.

Selon les modes de réalisation décrits, on surveille le fonctionnement du composant et on estime sa durée de vie restante plutôt que son vieillissement.

Cette surveillance est, dans le mode de réalisation de la figure 1, effectuée par un circuit électronique 5 lié ou associé au condensateur 1, et reliée à ses deux électrodes 12 et 14 (liaison symbolisée par des fils 62 et 64 reliant le circuit 5 aux deux électrodes 12 et 14 du condensateur 1). Le circuit 5 communique en outre, de préférence par une transmission sans fil (antenne 51) avec un serveur 7 ou un système distant de gestion de l'équipement 3. Le circuit 5 peut aussi être relié par une liaison électrique 101 à une sonde de température 100 placée contre ou dans le (au coeur du) condensateur 1.

Par circuit 5 lié au composant 1, on entend un circuit électronique qui se trouve physiquement et électriquement relié, de façon filaire, à l'équipement auquel est associé le composant. En d'autres termes, le circuit 5 est porté par, contenu ou "embarqué" dans, l'équipement 3 comme l'est le composant à surveiller. Avantageusement, le circuit 5 peut être porté par, contenu ou "embarqué" dans le condensateur 1, plus précisément dans un boîtier du condensateur comme illustré en figure 5. Dans ce cas, le circuit 5 est associé au condensateur lors de la fabrication de ce dernier. De préférence, le circuit de surveillance 5 est physiquement intégré au composant 1 lors de la fabrication de ce dernier.

Le circuit 5 est, selon les modes de réalisation décrits, un circuit autonome, réalisant des mesures de grandeurs physiques, côté condensateur, et calculant, de façon interne, au moins une grandeur représentative de la durée de vie restante. De préférence, les grandeurs physiques mesurées côté condensateur sont la tension à ses bornes et sa température.

Le système distant 7 peut prendre toute forme usuelle dans ce type d'application. Il s'agit, par exemple, de la salle de commande d'installation de production d'énergie, d'une centrale de gestion d'incidents de fonctionnement, etc. Il peut également s'agir d'un dispositif d'interrogation sans fil de type tablette, smartphone, lecteur sans contact de communication en champ proche (NFC - Near Field Communication) ou de radio-identification (RFID - radio frequency identification).

A la différence de la plupart des système usuels, on prévoit d'effectuer l'estimation de la durée de vie restante au niveau du circuit 5 associé au condensateur à surveiller. De préférence, le circuit 5 ne transmet pas au système distant (le serveur 7) les mesures effectuées, mais un résultat représentatif de la durée de vie restante. Ainsi, on réduit considérablement le volume de données à transmettre, ce qui participe à une réduction de l'énergie consommée par le circuit 5.

La figure 2 représente, de façon très schématique et sous forme de blocs, un mode de réalisation d'un circuit 5 de surveillance d'un composant.

Selon ce mode de réalisation, le circuit 5 comporte un microcontrôleur 52 ($\mu$C) dont le rôle est d'interpréter les mesures des grandeurs physiques prises en compte, de calculer le résultat de l'estimation de durée de vie restante et d'organiser sa transmission vers le système distant 7. Le microcontrôleur 52 est associé à une mémoire non volatile réinscriptible 53 (NVM) destinée notamment à stocker le résultat de l'estimation, et à une interface d'entrée-sortie 54 (I/O) à destination de l'antenne 51 par l'intermédiaire d'un circuit d'émission-réception radiofréquence 55 (RF).

Par ailleurs, le circuit 5 comporte et/ou est relié à des capteurs de grandeurs physiques du composant surveillé. Dans l'exemple représenté, ces grandeurs physiques sont la tension V aux bornes du condensateur 1 et les températures Te en périphérie (57) et Te au coeur (100) du condensateur 1. Le circuit gère donc des capteurs ou circuits de mesure (blocs 56, V, bloc 57, Te et/ou bloc 100, Tc) d'informations représentatives de la tension V et des températures. Selon le cas, la température la plus significative pour l'état de fonctionnement et l'estimation de durée de vie peut se situer, soit au coeur du condensateur (mesure assurée par le capteur 100), soit sur sa périphérie (mesure assurée par le capteur 57). Le capteur de température 57 peut se situer sur la carte électronique du circuit 5. Ainsi, selon un mode de réalisation, le circuit de surveillance (5) utilise au moins deux mesures de température réparties dans ou sur le composant (1), de sorte à détecter les variations de température susceptibles de se produire de façon localisée en différents points du composant, par exemple en périphérie et au coeur du composant.

Si les grandeurs analogiques fournies par les capteurs 56, 57 et 100 sont analogiques, alors elles sont converties en données numériques, interprétables par le microcontrôleur 52 par un ou plusieurs convertisseurs analogique-numérique 58 (ADC).

Le circuit 5 peut comporter en outre d'autres éléments et fonctions, symbolisés par un bloc 60 (FCT ou fonction) en figure 2, en fonction de l'application. Par exemple, il peut s'agir :

- de capteurs de grandeurs physiques différentes (par exemple le courant, la pression, l'humidité, etc.) selon la nature du composant à surveiller ;
- de circuits de transmissions spécifiques (Bluetooth, Wifi, GSM, RFID, USB, etc.) ;
- de circuits logiques matériels ; et/ou
- de mémoires volatiles et/ou non volatiles supplémentaires.

Selon les modes de réalisation décrits, le circuit 5 tire l'énergie nécessaire au fonctionnement des circuits qu'il comporte de l'énergie présente dans l'équipement qu'il surveille. En effet, bien qu'il soit possible d'équiper le circuit 5 d'une batterie, cela ne constitue pas un mode de réalisation préféré dans la mesure où cela rend la réalisation des mesures et la restitution de l'estimation de durée de vie restante tributaires de la charge de la batterie. En particulier, il faudrait alors également prévoir un système d'estimation de la durée de vie restante de la batterie.

Ainsi, dans le mode de réalisation de la figure 2, le circuit 5 comporte un dispositif 66 de conversion d'énergie, par exemple de type alimentation à découpage, capable de prélever de l'énergie entre les bornes 12 et 14 du condensateur 1 via les connections 62 et 64, ou plus généralement sur l'équipement de puissance 3, et de fournir une basse tension (typiquement de quelques volts) pour alimenter les différents constituants du circuit 5. De préférence, le circuit de surveillance 5 est ainsi alimenté directement aux bornes du composant 1.

En variante, on pourra prévoir un prélèvement d'énergie sur d'autres éléments de l'équipement ou de l'installation comportant cet équipement, pourvu que soient prévus les éléments de conversion et d'isolation adaptés à la tension relativement basse d'alimentation du circuit 5 par rapport à la tension relativement haute présente au niveau de l'équipement ou de l'installation.

Le circuit 5 met en oeuvre un traitement spécifique à partir des mesures effectuées. De préférence, ce traitement :

- prévoit l'estimation de la durée de vie restante avec une fréquence suffisamment élevée pour assurer la fiabilité du calcul de vieillissement, par exemple comprise entre la seconde et la minute, afin d'économiser l'énergie prélevée sur l'équipement portant ou auquel est attaché le composant surveillé ;
- conduit à un résultat en termes de durée de vie restante, afin de minimiser le flux de données à transmettre et, par ce biais, la consommation du circuit 5 ;
- est robuste à la disparition d'énergie aux bornes 12 et 14 du condensateur, la durée de vie restante et les paramètres de fonctionnement étant stockés en mémoire non volatile 53 et rechargés (remplacés) à chaque réapparition de l'énergie, et étant ensuite mis à jour à chaque cycle de traitement du circuit 5 ;

- prévoit la transmission du dernier résultat estimé avec une fréquence relativement faible, par exemple comprise entre l'heure et la semaine, non nécessairement identique à la fréquence des estimations ; et/ou
- est capable de générer une alerte à destination du système distant en cas de détection d'un dépassement des conditions opérationnelles du composant surveillé (par exemple, une tension et/ou une température dépassée, typiquement 1500 V ou 85°C pour un condensateur de puissance) .

En particulier, on considère qu'il n'est dans la plupart des applications pas nécessaire de communiquer au système distant l'intégralité des mesures afin que ce dernier estime l'allure du vieillissement et en déduise la durée de vie restante. En effet, ce qui importe du point de vue de l'équipement, c'est de détecter, suffisamment tôt pour éviter une panne, un besoin de remplacement du composant surveillé ou d'intervention de maintenance sur ce dernier.

Ainsi, on prévoit de communiquer au système distant une information sur le résultat de l'estimation de durée de vie restante plutôt que l'ensemble des mesures. L'interprétation des mesures est donc effectuée principalement au niveau du circuit 5.

De préférence, le circuit 5 est également capable, à partir des mesures, de générer une alerte ou alarme indicatrice d'un dysfonctionnement au niveau de l'équipement ou d'un dépassement des conditions opérationnelles. Cela permet de déclencher une intervention de maintenance indépendamment de la transmission de la durée de vie restante du condensateur 1.

Par ailleurs, la périodicité ou fréquence des mesures, des calculs et des transmissions est choisie en fonction de la consommation souhaitée du circuit 5. De préférence, cette consommation est négligeable vu de l'équipement 3 et s'apparente à la consommation liée aux fuites des différents constituants de l'équipement. On tire ici profit du fait que ce qui importe est principalement de communiquer une information relative à la durée de vie restante. Ainsi, hormis les cas d'alarmes transmettant un dysfonctionnement pour lesquels une transmission spécifique (hors des périodes de transmission de la durée de vie) peut être prévue, une fréquence de l'ordre de l'heure, voire de la journée, de la semaine ou plus peut être suffisante, eu égard au temps requis pour l'organisation d'opérations de maintenance.

Dans les systèmes usuels, la connaissance des détails de mesure et de leur évolution est en fait surtout utile pour le fabriquant du composant afin de disposer de données statistiques en exploitation réelle. Toutefois, du point de vue de l'utilisateur ou exploitant de l'équipement 3, ce qui importe c'est d'être averti à temps lorsqu'il faut intervenir sur le composant.

Ainsi, le fait de ne transmettre qu'une information se contentant de contenir la durée de vie restante ou une alerte de dysfonctionnement n'est pas gênant. Par ailleurs, on peut prévoir une fréquence d'évaluation de la durée de vie plus importante que la fréquence d'envoi de l'information au système distant. Dans la mesure où les transmissions sans fils sont les opérations qui consomment beaucoup par rapport au calcul de la durée de vie restante, cela permet d'optimiser la consommation d'énergie sans nuire à la détection d'un éventuel problème. En particulier, on peut prévoir, en cas de besoin d'une alerte de dysfonctionnement, une transmission immédiate, indépendamment de la fréquence de transmission définie pour la valeur représentative de la durée de vie restante.

Dans la plupart des applications requérant une estimation de la durée de vie d'un composant, on dispose de modèles permettant d'estimer cette durée de vie par rapport à une durée de vie nominale et à des conditions de fonctionnement du composant.

Dans l'exemple des condensateurs 1 de type film et selon l'invention, une relation liant la durée de vie restante (estimée) DDV à la durée de vie nominale DDVn prend la forme suivante :

$$\frac{DDV}{DDVn} = \left(\frac{V}{Vn}\right)^{-8} 2^{(Tn-T)/15} \quad \text{(équation 1),}$$

où V représente la valeur courante de la tension mesurée aux bornes du condensateur, Vn représente la valeur de la tension nominale aux bornes du condensateur, T représente la valeur courante de la température de fonctionnement du condensateur, et Tn représente la valeur de la température nominale de fonctionnement du condensateur.

La température courante T de fonctionnement du condensateur, utilisée pour le calcul de la durée restante, peut être calculée à partir de mesures des deux capteurs 57 et 100. Par exemple, la température moyenne des températures mesurées par les deux capteurs, ou la température maximale parmi les températures mesurées par les deux capteurs, peut être utilisée dans le calcul de durée de vie.

Selon un mode de mise en oeuvre préféré, on tient compte des valeurs courantes à la fois afin de détecter une éventuelle sortie d'une zone acceptable de fonctionnement et de calculer la durée de vie restante.

Cette mise en oeuvre exploite, de préférence, un gabarit de définition de zones de fonctionnement du composant en fonction des grandeurs physiques, ici la tension V et la température T, mesurées.

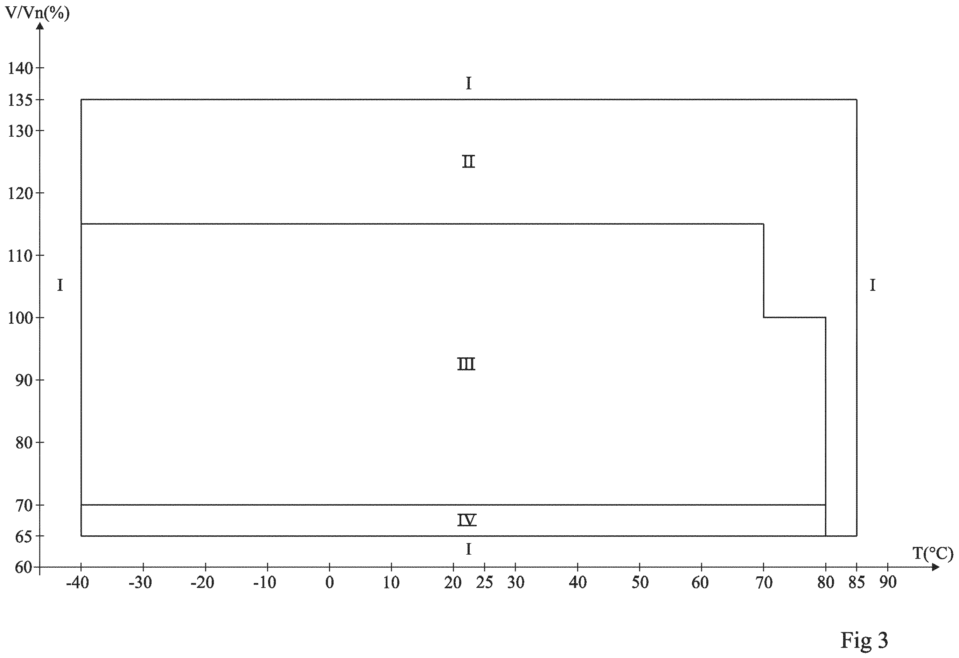

La figure 3 représente, de façon schématique, un exemple de gabarit de définition de zones de fonctionnement d'un condensateur.

Selon cet exemple, le gabarit permet de définir des zones de fonctionnement en fonction de la température courante T et du rapport V/Vn (en %) entre la tension courante V et la tension nominale Vn.

Le gabarit peut être établi, en fonction de l'application, par simulation ou à partir de modèles de fonctionnement et/ou de vieillissement d'un condensateur.

Dans l'exemple de la figure 3, on considère les quatre zones suivantes.

Une première zone I, non fonctionnelle, dans laquelle le circuit électronique 5 lui-même ne se trouve pas dans des conditions de fonctionnement acceptables. L'entrée dans cette zone peut donc générer une alarme sur les conditions opérationnelles et peut positionner l'indicateur de durée de vie restante à 0. Cette zone correspond ici :

- à des températures extrêmes, par exemple inférieures à environ -40°C, de préférence inférieures à -40°C, ou supérieure à environ 85°C, de préférence supérieures à 85°C ; ou
- à des tensions V extrêmes, par exemple inférieures à environ 70% de la tension nominale Vn, de préférence inférieures à 70% de la tension nominale Vn, ou supérieures à environ 135% de la tension nominale Vn, de préférence supérieures à 135% de la tension nominale Vn.

Une deuxième zone II dans laquelle on considère une situation requérant l'émission d'une alerte ou d'une alarme, de préférence immédiate. L'entrée dans cette zone génère une alarme sur les conditions opérationnelles et positionne l'indicateur de durée de vie restante à zéro (0). Cette zone correspond ici, par exemple :

- à des tensions V comprises entre environ 115% et environ 135% de la tension nominale Vn, de préférence comprises entre 115% et 135% de la tension nominale Vn, pour des températures comprises entre environ -40°C et environ 85°C, de préférence comprises entre -40°C et 85°C ;
- à des tensions V comprises entre environ 100% et environ 135% de la tension nominale Vn, de préférence comprises entre 100% et 135% de la tension nominale Vn, pour des températures comprises entre environ 70°C et environ 85°C, de préférence comprises entre 70°C et 85°C ; ou
- à des tensions V comprises entre environ 65% et environ 135% de la tension nominale Vn, de préférence comprises entre 65% et 135% de la tension nominale Vn, pour des températures comprises entre environ 80°C et environ 85°C, de préférence comprises entre 80°C et 85°C.

Une troisième zone III dans laquelle on considère une situation requérant l'estimation de la durée de vie restante. Cette zone correspond ici, par exemple :

- à des tensions V comprises entre environ 70% et environ 115% de la tension nominale Vn, de préférence comprises entre 70% et 115% de la tension nominale Vn, pour des températures comprises entre environ -40°C et environ 70°C, de préférence comprises entre -40°C et 70°C ; ou
- à des tensions V comprises entre environ 70% et environ 100% de la tension nominale Vn, de préférence comprises entre 70% et 100% de la tension nominale Vn, pour des températures comprises entre environ 70°C et environ 80°C, de préférence comprises entre 70°C et 80°C.

Une quatrième zone IV (optionnelle) dans laquelle on considère que l'impact sur la durée de vie restante est négligeable et qu'il n'est même pas nécessaire de la modifier. Cette zone correspond ici, par exemple :

- à des tensions V comprises entre environ 65% et environ 70% de la tension nominale Vn, de préférence comprises entre 65% et 70% de la tension nominale Vn, pour des températures comprises entre environ -40°C et environ 80°C, de préférence comprises entre -40°C et 80°C.

En pratique, la détermination de la zone de fonctionnement dans laquelle se trouve le composant s'effectue de préférence par comparaison des mesures de la tension V et de la température T par rapport à des seuils représentatifs des limites des zones de fonctionnement.

Les zones de fonctionnement correspondent à des zones de l'espace tension/température, avec une zone "centrale" III autour d'un couple tension Vn et température Tn nominales, au moins une zone "périphérique" II de fonctionnement dégradé du condensateur différente d'une zone de "non-fonctionnement" I dans laquelle la tension d'alimentation et la température ne permettent plus au circuit de surveillance 5 de fonctionner.

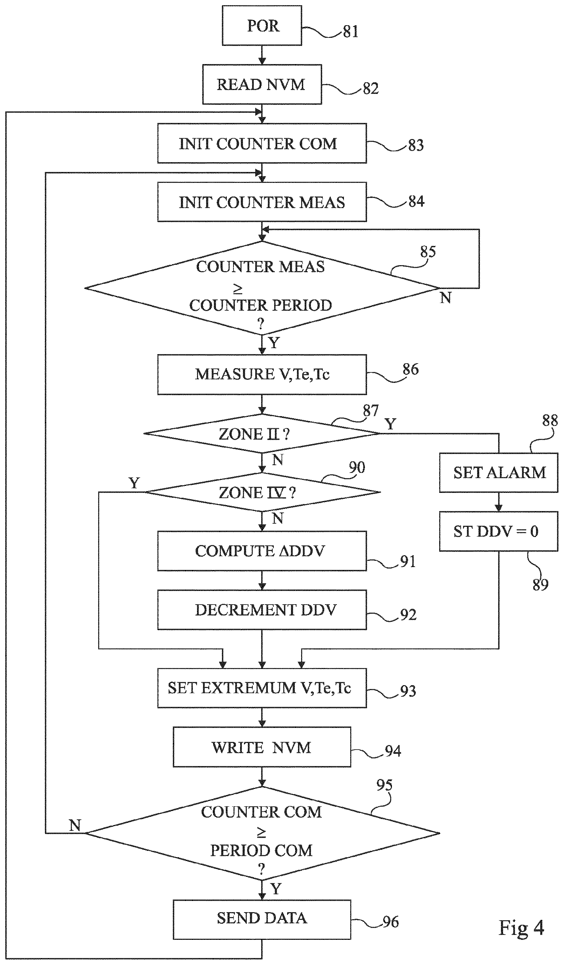

La figure 4 représente, de façon très schématique et sous forme de blocs, des étapes d'un mode de mise en oeuvre d'un procédé de surveillance (du fonctionnement) d'un composant.

Ce processus est mis en oeuvre périodiquement, avec une fréquence définie en fonction de l'application et des intervalles acceptables, entre deux mesures et entre deux transmissions de la durée de vie restante.

On note qu'il peut être impossible, pour le circuit 5, de déterminer s'il se trouve dans la première zone I non fonctionnelle.

Selon le mode de mise en oeuvre de la figure 4, on prévoit de stocker, dans la mémoire non volatile :

- les paramètres nominaux tels que la durée de vie initiale ou nominale DDVn, la tension nominale Vn, la température nominale Tn et les limites de zones sous la forme par exemple de seuils de température et de tension ;
- une valeur représentative de la durée de vie restante DDV ;
- les valeurs extrêmes mesurées de tension et de température ;
- une ou plusieurs éventuelles alarmes.

Le circuit 5 contient également, par exemple dans la mémoire 53 (figure 2), les coefficients et/ou l'algorithme d'estimation de la durée de vie restante (application de l'équation 1 dans cet exemple).

Selon un mode de réalisation, on utilise un compteur indiquant la durée de vie restante. Ce compteur est initialisé lors de la première mise sous tension à une valeur correspondant à la durée de vie nominale. En outre, lors de chaque nouvelle mise en route du circuit (par exemple après chaque coupure d'alimentation), la valeur DDV mémorisée dans la mémoire non volatile est utilisée pour réinitialiser le compteur.

De préférence, à chaque fois que la durée de vie doit être diminuée, on met à jour (décrémente) la valeur du compteur représentatif de la valeur DDV. Ainsi, les transmissions vers le système distant 7 se limitent, de préférence, à un message d'alarme lors d'un dysfonctionnement ou à la transmission périodique de la valeur DDV (la valeur du compteur stocké en mémoire 53). Les transmissions sont donc particulièrement courtes et peu gourmandes en énergie par rapport aux solutions usuelles.

A chaque itération du procédé illustré par la figure 4, à la montée d'alimentation suite à une réinitialisation (bloc 81, POR - Power On Reset) du dispositif de gestion d'énergie 66 (figure 2), le microcontrôleur 52 (figure 2) commence par s'initialiser puis par lire (bloc 82, READ NVM) les paramètres précédents de fonctionnement, de calibration (les extremums des grandeurs V, Te et Tc), d'alarme et de durée de vie restante DDV dans la mémoire non volatile 53. Le microcontrôleur initialise ensuite (bloc 83, INIT COUNTER COM, bloc 84, INIT COUNTER MEAS) des compteurs temporels (COM, MEAS) régulant les périodes de mesure (MEAS) et de transmission (COM).

Le microcontrôleur attend ensuite (bloc 85, COUNTER MEAS >= COUNTER PERIOD ?) en mode veille (sortie N du bloc 85) le temps COUNTER PERIOD de la période de mesure, puis se réveille (sortie Y du bloc 85) pour effectuer (bloc 86, MEASURE V, Te, Tc) les mesures courantes de la tension V et des températures Te et Te, fournies par les capteurs 56, 57 et 100.

Puis, le microcontrôleur 52 détermine ou évalue (bloc 87, ZONE II ?) si le composant se situe dans la deuxième zone (II) de fonctionnement.

Dans l'affirmative (sortie Y du bloc 87), une alarme est levée (bloc 88, SET ALARM), par exemple en positionnant une valeur prédéfinie dans un registre d'alarme. Selon un autre mode de réalisation, non illustré, on peut prévoir de déclencher, à la place ou en plus de l'alarme, une transmission de données et/ou l'émission d'un message d'alerte ou d'alarme à destination du système distant 7. Le microcontrôleur efface également le compteur DDV de durée de vie restante en le positionnant à zéro (bloc 89, DDV=0).

Si le composant ne se trouve pas dans la deuxième zone de fonctionnement (sortie N du bloc 87), le microcontrôleur 52 détermine (bloc 90, ZONE IV ?) si le composant est dans la quatrième zone de fonctionnement (IV).

Si le composant ne se trouve pas dans la quatrième zone (sortie N du bloc 90), c'est qu'il se trouve dans la troisième zone de fonctionnement. Le microcontrôleur 52 estime alors (bloc 91, COMPUTE ΔDDV) une variation de la durée de vie restante DDV par application du modèle (formule Math 1) de détermination, stocké dans le circuit 5, en fonction de la période de mesure et des valeurs de tension et de températures. Le résultat de cette détermination est répercuté dans le compteur de stockage de la valeur DDV, par exemple en décrémentant ce compteur (bloc 92, DECREMENT DDV).

Le microcontrôleur 52 évalue ensuite si les valeurs de tension et de températures nouvellement mesurées ont dépassé les valeurs des précédentes mesures stockées dans la mémoire non volatile, afin d'assurer un relevé des extremums (bloc 93, SET EXTREMUM V, Te, Tc).

Si le composant se trouve dans la quatrième zone de fonctionnement (sortie Y du bloc 90), cela signifie qu'un calcul de la durée de vie restante n'est pas nécessaire. Le processus passe alors directement à l'étape 93. Cette étape 93 est également effectuée une fois que, dans le cas où le composant est dans la deuxième zone de fonctionnement (sortie Y du bloc 87), les étapes 88 et 89 ont été achevées.

Une fois que les extremums ont été déterminés, les valeurs du compteur de durée de vie restante, d'alarmes et de niveaux extremums sont stockées dans la mémoire non volatile (bloc 84, WRITE NVM) afin de ne pas perdre le résultat des actualisations en cas de coupure de l'alimentation.

Le microcontrôleur vérifie ensuite s'il est temps de transmettre les données en fonction de la période PERIOD COM de communication programmée (bloc 95, COUNTER COM >= PERIOD COM ?).

Dans l'affirmative (sortie Y du bloc 95), le microcontrôleur 52 déclenche (bloc 96, SEND DATA) l'émission radio des messages d'alerte, de fonctionnement et de durée de vie restante. Puis, le microcontrôleur retourne en mode veille (via les blocs 83 et 84) en attente d'un nouveau cycle de mesure ou de communication.

Dans la négative (sortie N du bloc 95), le microcontrôleur retourne directement en mode veille (via le bloc 84) .

Comme déjà mentionné, les fréquences d'estimation de la durée de vie restante DDV et de transmission de cette durée de vie restante ne sont pas nécessairement les mêmes. On peut ainsi adapter, en fonction de l'application, la fréquence de mise en oeuvre des étapes illustrées par la figure 4 à l'intervalle requis pour avertir le système distant, et la fréquence de transmission de la durée de vie restante DDV au système distant à l'intervalle souhaité entre deux mises à jour, côté système distant.

En pratique, la recherche de la zone de fonctionnement dans laquelle se trouve le condensateur est effectuée en application du procédé décrit en relation avec la figure 4 est réalisée avec une fréquence choisie en fonction de (ou correspondant à) la fréquence avec laquelle sont effectuées les mesures de températures et de tension. Le résultat (la zone de fonctionnement obtenue) est utilisé pour décider d'une opération à effectuer (notamment l'ajustement de la durée de vie restante), conduisant à la mise à jour de paramètres en mémoire non volatile lorsque l'on se trouve en zone II (mais pas lorsque l'on se trouve en zone IV).

Selon un mode de réalisation, le microcontrôleur déclenche périodiquement une transmission de la valeur DDV au système distant 7.

Selon un mode de réalisation, le calcul d'une durée de vie restante DDV nulle ou inférieure à un seuil déclenche l'émission d'un signal, de préférence à destination du système distant afin de permettre une intervention sur l'équipement. La fixation du seuil dépend de l'application.

Selon un mode de réalisation, le système distant interroge périodiquement le circuit 5 (la lecture et transmission de la valeur DDV dans la mémoire non volatile 53). En effet, à tout moment, le compteur correspondant en mémoire 53 contient la dernière valeur mise à jour de la durée de vie restante du condensateur.

On notera que le système n'évalue pas les effets du vieillissement du composant, mais de préférence seulement sa durée de vie restante. Cela participe à la faible consommation du circuit 5.

La figure 5 représente, de façon schématique, une vue en perspective d'un mode de réalisation d'un composant 1.

Selon ce mode de réalisation, le composant 1 comporte un boîtier dans lequel est logé le condensateur (non visible en figure 5) dont deux électrode ou bornes 12 et 14 sortent du haut du boîtier en traversant une carte électronique constituant le circuit de surveillance 5. Les différents circuits constitutifs du circuit de surveillance (figure 2) sont référencés 59 en figure 5. La carte est traversée par les bornes 12 et 14 de raccordement du condensateur. Le boîtier 13 intègre également les deux capteurs de température 57 et 100 de la figure 2. Dans l'exemple représenté, le capteur 100 est placé à l'intérieur du condensateur, par exemple au coeur du condensateur, par exemple si le condensateur est réalisé à partir d'un enroulé, au centre de l'enroulé. Le capteur 57 de température en périphérie est situé sur la carte 5. Ainsi, l'ensemble décrit ne comporte que deux bornes 12 et 14 d'accès filaire avec l'extérieur constitués des bornes de connexion aux électrodes du condensateur (plus, le cas échéant, des éléments de communication sans fil). Le reste des connexions requises pour le fonctionnement décrit est inclus dans le boîtier 1. Cela revient, comme mentionné plus haut, à considérer le circuit de surveillance est contenu ou "embarqué" dans le condensateur en étant physiquement intégré au composant 1 lors de la fabrication de ce dernier.

Divers modes de réalisation et variantes ont été décrits. L'homme de l'art comprendra que certaines caractéristiques de ces divers modes de réalisation et variantes pourraient être combinées, et d'autres variantes apparaîtront à l'homme de l'art.

Par ailleurs, bien que l'on ait décrit un exemple se rapportant à une mise à jour par décroissance de la durée de vie, les modes de réalisation décrits se transposent sans difficulté à un système dans lequel le composant surveillé est susceptible de se régénérer au moins partiellement, le compteur représentatif de la durée de vie restante étant alors mis à jour par incrément ou décrément.

En outre, bien que l'on ait fait référence à un microcontrôleur 52 pour effectuer les calculs requis, on pourra sans difficulté remplacer ce microcontrôleur par un circuit en logique câblée ou un circuit intégré à cellules logiques programmables (FPGA - Field Programmable Gate Array) . De même, on pourra prévoir de réaliser tout ou partie du circuit 5 au moyen d'un ou plusieurs circuits intégrés propres à une application donnée (ASIC - Application-Specific Integrated Circuit).

Enfin, la mise en oeuvre pratique des modes de réalisation et variantes décrits est à la portée de l'homme du métier à partir des indications fonctionnelles données ci-dessus. En particulier, la programmation du microcontrôleur 52 pour une implémentation logicielle des modes de réalisation décrits est à la portée de l'homme du métier, de même que la réalisation de circuits en logique câblée pour une mise en oeuvre en tout ou partie matérielle.

**Revendications**

1. Circuit (5) de surveillance du fonctionnement d'un composant (1) comportant un condensateur et étant associé à un équipement (3), le circuit comportant :

   au moins un dispositif (56, 57, 100) de mesure de la tension (V) aux bornes du condensateur et de la température (Te, Tc) du condensateur ; et
   un circuit (52) de calcul d'une valeur représentative d'une durée de vie restante (DDV) du composant, appliquant la formule suivante :

   $$\frac{DDV}{DDVn} = \left(\frac{V}{Vn}\right)^{-8} 2^{(Tn-T)/15}$$

   où DDVn représente la valeur nominale de la durée de vie du condensateur (1), V représente la valeur courante de la tension mesurée aux bornes du condensateur, Vn représente la valeur de la tension nominale aux bornes du condensateur, T représente la valeur courante de la température de fonctionnement du condensateur, et Tn représente la valeur de la température nominale de fonctionnement du condensateur ;
   ledit circuit de surveillance (5) étant configuré pour être physiquement intégré au composant (1) lors de la fabrication de ce dernier et étant configuré pour être alimenté directement aux bornes du condensateur ; et
   ledit calcul utilisant au moins deux mesures de température réparties dans ou sur le condensateur (1), de sorte à détecter les variations de température susceptibles de se produire de façon localisée en différents points du condensateur.

2. Procédé de surveillance du fonctionnement d'un composant (1) comportant un condensateur et associé à un équipement (3), comportant les étapes de :

   mesurer (86) la tension (V) aux bornes du condensateur et la température (Te, Tc) du condensateur ; et
   calculer (89, 91, 92) une valeur représentative d'une durée de vie restante (DDV) du composant, appliquant la formule suivante :

   $$\frac{DDV}{DDVn} = \left(\frac{V}{Vn}\right)^{-8} 2^{(Tn-T)/15}$$

   où DDVn représente la valeur nominale de la durée de vie du condensateur (1), V représente la valeur courante de la tension mesurée aux bornes du condensateur, Vn représente la valeur de la tension nominale aux bornes du condensateur, T représente la valeur courante de la température de fonctionnement du condensateur, et Tn représente la valeur de la température nominale de fonctionnement du condensateur.
   ledit calcul :

     étant effectué dans un circuit (5) physiquement intégré au composant (1) lors de la fabrication de ce dernier et étant alimenté directement aux bornes du condensateur ; et
     utilisant au moins deux mesures de température réparties dans ou sur le condensateur (1), de sorte à détecter les variations de température susceptibles de se produire de façon localisée en différents points du condensateur.

3. Circuit selon la revendication 1 ou procédé selon la revendication 2, dans lequel le composant est constitué d'un boîtier (13) dans lequel sont positionnés ledit condensateur, ledit circuit de surveillance, deux capteurs de température, ledit boîtier comportant deux et seulement deux bornes (12, 14).

4. Circuit selon la revendication 1 ou 3, ou procédé selon la revendication 2 ou 3, dans lequel la valeur représentative de la durée de vie restante (DDV) est stockée de façon non volatile (53, 94) dans le circuit de surveillance (5).

5. Circuit selon la revendication 1, 3 ou 4, ou procédé selon l'une quelconque des revendications 2 à 4, dans lequel ladite valeur représentative de la durée de vie restante (DDV) est transmise à un système distant (7), par liaison sans fil.

6. Circuit ou procédé selon la revendication 5, dans lequel la fréquence de transmission de ladite valeur représentative de la durée de vie restante (DDV) est inférieure à la fréquence de calcul de cette valeur.

7. Circuit selon l'une quelconque des revendication 1, 3 à 6, ou procédé selon la revendication 2 à 6, dans lequel :

des mesures courantes de tension et de température (V, Te, Tc) sont comparées à des seuils pour déterminer une zone de fonctionnement (II, III, IV) dans laquelle se trouve le condensateur (1), les zones de fonctionnement correspondant à des zones de l'espace tension/température, avec une zone "centrale" (III) autour d'un couple tension (Vn) et température (Tn) nominales, au moins une zone "périphérique" (II) de fonctionnement dégradé du condensateur différente d'une zone de "non-fonctionnement" (I) dans laquelle la tension d'alimentation et la température ne permettent plus au circuit de surveillance (5) de fonctionner ;
la zone de fonctionnement dans laquelle se trouve le condensateur conditionnant le stockage d'un paramètre de façon non volatile dans le circuit de surveillance (5).

8. Circuit ou procédé selon la revendication 7, dans lequel la zone de fonctionnement (II, III, IV) du condensateur (1) conditionne la mise en oeuvre du calcul de la valeur représentative de la durée de vie (DDV) et son stockage en mémoire non volatile.

9. Circuit ou procédé selon la revendication 8, dans lequel, dans une zone de fonctionnement, aucune mise à jour de la valeur représentative de la durée de vie restante n'est effectuée.

10. Circuit ou procédé selon l'une quelconque des revendications 7 à 9, dans leur rattachement à la revendication 5, dans lequel une zone de fonctionnement (II) conditionne en outre l'émission (88) d'un signal représentatif d'un dysfonctionnement du condensateur à destination du système distant (7).

11. Circuit ou procédé selon la revendication 10, dans lequel un compteur de durée de vie restante est effacé en le positionnant à zéro.

12. Circuit selon l'une quelconque des revendications 1, 3 à 11, ou procédé selon l'un quelconque des revendications 2 à 11, dans lequel le calcul de la valeur représentative de la durée de vie restante (DDV) est effectué à une fréquence comprise entre une seconde et une minute.

13. Circuit selon l'une quelconque des revendications 1, 3 à 12, ou procédé selon l'une quelconque des revendications 2 à 12, dans lequel lesdits points du condensateur comportent des points en périphérie et au coeur du composant.

14. Circuit selon l'une quelconque des revendications 1, 3 à 13, ou procédé selon l'une quelconque des revendication 2 à 13, dans lequel la température prise en compte pour le calcul de la durée de vie restante est égale à la moyenne des températures mesurées par les capteurs de température (57, 100) .

15. Circuit ou procédé selon la revendication 14, dans lequel la température prise en compte pour le calcul de la durée de vie restante est égale à la valeur maximale parmi les températures mesurées par les capteurs de température (57, 100) .

16. Circuit selon l'une quelconque des revendications 1, 3 à 15, ou procédé selon l'une quelconque des revendications 2 à 15, dans lequel une durée de vie restante nulle ou inférieure à un seuil déclenche l'émission d'un signal.

17. Système comportant :

un équipement (3) ;
un composant (1) associé à l'équipement ; et
un circuit (5) selon l'une quelconque des revendication 1, 3 à 16.

**Patentansprüche**

1. Schaltung (5) zum Überwachen des Betriebs eines Bestandteils (1), die einen Kondensator aufweist und mit einer Einrichtung (3) verknüpft ist, wobei die Schaltung Folgendes aufweist:

wenigstens eine Vorrichtung (56, 57, 100) zum Messen der Spannung (V) an den Anschlüssen des Kondensators und der Temperatur (Te, Tc) des Kondensators; und

eine Schaltung (52) zur Berechnung eines Wertes, der für eine Restlebensdauer (DDV, DDV = Durée de Vie Restante) des Bestandteils repräsentativ ist, unter Anwendung der folgenden Formel:

$$\frac{DDV}{DDVn} = \left(\frac{V}{Vn}\right)^{-8} 2^{(Tn-T)/15}$$

wobei DDVn den Nennwert der Lebensdauer des Kondensators (1) darstellt, V den aktuellen Wert der gemessenen Spannung über dem Kondensator darstellt, Vn den Wert der Nennspannung über dem Kondensator darstellt, T den aktuellen Wert der Betriebstemperatur des Kondensators darstellt, und Tn den Wert der Nennbetriebstemperatur des Kondensators darstellt,

wobei die Schaltung zum Überwachen (5) bei dessen Herstellung physisch in das Bestandteils (1) integriert wird, und direkt über den Kondensator gespeist wird, und wobei die Berechnung wenigstens zwei Temperaturmessungen verwendet, die in oder auf dem Kondensator (1) verteilt sind, um Temperaturänderungen zu detektieren, die wahrscheinlich lokal an verschiedenen Punkten des Kondensators auftreten.

2. Verfahren zum Überwachen des Betriebs eines Bestandteils (1), der einen Kondensator aufweist und mit einer Einrichtung (3) verbunden ist, wobei das Verfahren die folgenden Schritte aufweist:

Messen (86) der Spannung (V) an den Anschlüssen des Kondensators und der Temperatur (Te, Tc) des Kondensators; und

Berechnen (89, 91, 92) eines Wertes, der für eine Restlebensdauer (DDV, DDV = Durée de Vie Restante) des Bestandteils repräsentativ ist, unter Anwendung der folgenden Formel:

$$\frac{DDV}{DDVn} = \left(\frac{V}{Vn}\right)^{-8} 2^{(Tn-T)/15}$$

wobei DDVn den Nennwert der Lebensdauer des Kondensators (1) darstellt, V den aktuellen Wert der gemessenen Spannung über dem Kondensator darstellt, Vn den Wert der Nennspannung über dem Kondensator darstellt, T den aktuellen Wert der Betriebstemperatur des Kondensators darstellt, und Tn den Wert der Nennbetriebstemperatur des Kondensators darstellt,

wobei die Berechnung:

in einer Schaltung (5) durchgeführt wird, die bei der Herstellung des Bestandteils (1) physisch in diesen integriert ist und direkt an den Anschlüssen des Kondensators mit Strom versorgt wird, und

wenigstens zwei Temperaturmessungen verwendet, die in oder auf dem Kondensator (1) verteilt sind, um Temperaturänderungen zu detektieren, die wahrscheinlich lokal an verschiedenen Punkten des Kondensators auftreten.

3. Schaltung nach Anspruch 1 oder Verfahren nach Anspruch 2, wobei der Bestandteil aus einem Gehäuse (13) besteht, in dem der Kondensator, die Schaltung zur Überwachung und zwei Temperatursensoren positioniert sind, wobei das Gehäuse zwei und nur zwei Anschlüsse (12, 14) aufweist.

4. Schaltung nach Anspruch 1 oder 3 oder Verfahren nach Anspruch 2 oder 3, wobei der für die Restlebensdauer (DDV) repräsentative Wert nichtflüchtig (53, 94) in der Schaltung zur Überwachung (5) gespeichert wird.

5. Schaltung nach Anspruch 1, 3 oder 4 oder Verfahren nach einem der Ansprüche 2 bis 4, wobei der für die Restlebensdauer repräsentative Wert (DDV) über eine drahtlose Verbindung an ein entferntes System (7) übertragen wird.

6. Schaltung oder Verfahren nach Anspruch 5, wobei die Frequenz der Übertragung des für die Restlebensdauer repräsentativen Wertes (DDV) niedriger ist als die Frequenz der Berechnung dieses Wertes.

7. Schaltung nach einem der Ansprüche 1, 3 bis 6 oder Verfahren nach Anspruch 2 bis 6, wobei:

aktuelle Spannungs- und Temperaturmessungen (V, Te, Tc) mit Schwellenwerten verglichen werden, um einen Betriebsbereich (II, III, IV) zu bestimmen, in dem sich der Kondensator (1) befindet, wobei die Betriebsbereiche Bereichen des Spannungs-/Temperaturraums entsprechen, mit einer "zentralen" Zone (III) um ein Paar aus Nennspannung (Vn) und -temperatur (Tn), wenigstens eine "periphere" Zone (II) des verschlechterten Betriebs des Kondensators, die sich von einer "Nicht-funktionierenden" Zone (I) unterscheidet, in der es die Versorgungsspannung und die Temperatur der Schaltung zur Überwachung (5) nicht mehr ermöglichen, zu arbeiten; der Betriebsbereich, in dem sich der Kondensator befindet, die Speicherung eines Parameters auf nichtflüchtige Weise in der Schaltung zur Überwachung (5) bedingt.

8. Schaltung oder Verfahren nach Anspruch 7, wobei der Betriebsbereich (II, III, IV) des Kondensators (1) die Implementierung der Berechnung des für die Restlebensdauer repräsentativen Wertes (DDV) und dessen Speicherung in einem nichtflüchtigen Speicher bedingt.

9. Schaltung oder Verfahren nach Anspruch 8, wobei in einem Betriebsbereich keine Aktualisierung des für die Restlebensdauer repräsentativen Werts vorgenommen wird.

10. Schaltung oder Verfahren nach einem der Ansprüche 7 bis 9, in Abhängigkeit von Anspruch 5, wobei ein Betriebsbereich (II) zusätzlich das Senden (88) eines Signals, das für eine Fehlfunktion des Kondensators repräsentativ ist, an das entfernte System (7) bedingt.

11. Schaltung oder Verfahren nach Anspruch 10, wobei ein Zähler für die Restlebensdauer gelöscht wird, indem er auf Null gesetzt wird.

12. Schaltung nach einem der Ansprüche 1, 3 bis 11 oder Verfahren nach einem der Ansprüche 2 bis 11, wobei die Berechnung des für die Restlebensdauer repräsentativen Werts (DDV) mit einer Frequenz zwischen einer Sekunde und einer Minute durchgeführt wird.

13. Schaltung nach einem der Ansprüche 1, 3 bis 12 oder Verfahren nach einem der Ansprüche 2 bis 12, wobei die Punkte des Kondensators Punkte am Rand und im Kern des Bauteils aufweisen.

14. Schaltung nach einem der Ansprüche 1, 3 bis 13, oder Verfahren nach einem der Ansprüche 2 bis 13, wobei die Temperatur, die bei der Berechnung der Restlebensdauer berücksichtigt wird, gleich dem Durchschnitt der Temperaturen ist, die von den Temperatursensoren (57, 100) gemessen werden.

15. Schaltung oder Verfahren nach Anspruch 14, wobei die Temperatur, die bei der Berechnung der Restlebensdauer berücksichtigt wird, gleich dem Maximalwert unter den Temperaturen ist, die von den Temperatursensoren (57, 100) gemessen werden.

16. Schaltung nach einem der Ansprüche 1, 3 bis 15 oder Verfahren nach einem der Ansprüche 2 bis 15, wobei eine Restlebensdauer von null oder unterhalb eines Schwellenwerts die Ausgabe eines Signals auslöst.

17. System, das Folgendes aufweist:

   eine Einrichtung (3),
   ein Bestandteil (1), das mit der Einrichtung verbunden ist, und
   eine Schaltung (5) nach einem der Ansprüche 1, 3 bis 16.


**Claims**

1. Circuit (5) for monitoring a component (1) comprising a capacitor and being associated with equipment (3), the circuit comprising:

   at least one device (56, 57, 100) for measuring the voltage (V) across the capacitor and the temperature (Te, Tc) of the capacitor; and
   a circuit (52) for calculating a value representative of a remaining lifetime (DDV) of the component, applying the following formula:

$$\frac{DDV}{DDVn} = \left(\frac{V}{Vn}\right)^{-8} 2^{(Tn-T)/15}$$

where DDVn represents the nominal value of the lifetime of the capacitor (1), V represents the current value of the voltage measured across the capacitor, Vn represents the value of the nominal voltage across the capacitor, T represents the current value of the operating temperature of the capacitor, and Tn represents the value of the nominal operating temperature of the capacitor;

said monitoring circuit (5) being physically integrated to the component (1) on manufacturing thereof and being directly powered across the capacitor; and

said calculation using at least two temperature measurements distributed inside or on top of the capacitor (1), to detect temperature variations likely to occur locally at different points of the capacitor.

2. Method of monitoring the operation of a component (1) comprising a capacitor and associated with equipment (3), comprising the steps of:

measuring (86) the voltage (V) across the capacitor and the temperature (Te, Tc) of the capacitor; and

calculating (89, 91, 92) a value representative of a remaining lifetime (DDV) of the component, applying the following formula:

$$\frac{DDV}{DDVn} = \left(\frac{V}{Vn}\right)^{-8} 2^{(Tn-T)/15}$$

where DDVn represents the nominal value of the lifetime of the capacitor (1), V represents the current value of the voltage measured across the capacitor, Vn represents the value of the nominal voltage across the capacitor, T represents the current value of the operating temperature of the capacitor, and Tn represents the value of the nominal operating temperature of the capacitor,

said calculation:

being performed in a circuit (5) physically integrated to the component (1) on manufacturing thereof and being directly powered across the capacitor; and

using at least two temperature measurements distributed inside or on top of the capacitor (1), to detect temperature variations likely to locally occur at different points of the capacitor.

3. Circuit according to claim 1 or method according to claim 2, wherein the component is formed of a package (13) having said capacitor, said monitoring circuit, two temperature sensors positioned therein, said package comprising two and only two terminals (12, 14).

4. Circuit according to claim 1 or 3, or method according to claim 2 or 3, wherein the value representative of the remaining lifetime (DDV) is stored in non-volatile fashion (53, 94) in the monitoring circuit (5).

5. Circuit according to claim 1, 3 or 4, or method according to any of claims 2 to 4, wherein said value representative of the remaining lifetime (DDV) is transmitted to a distant system (7) over a wireless link.

6. Circuit or method according to claim 5, wherein the frequency of transmission of said value representative of the remaining lifetime (DDV) is smaller than the frequency of calculation of this value.

7. Circuit according to any of claims 1, 3 to 6, or method according to claim 2 to 6, wherein:

current voltage and temperature measurements (V, Te, Tc) are compared with thresholds to determine an operating zone (II, III, IV) where the capacitor (1) is located, the operating zones corresponding to zones of the voltage/temperature space, with a "central" zone (III) around a nominal voltage (Vn) and temperature (Tn) pair, at least one "peripheral" zone (II) of degraded operation of the capacitor different from a "non-functional" zone (I) where the power supply voltage and the temperature no longer enable the monitoring circuit (5) to operate; the operating zone where the capacitor is located conditioning the non-volatile storage of a parameter in the monitoring circuit (5).

8. Circuit or method according to claim 7, wherein the operating zone (II, III, IV) of the capacitor (1) conditions the implementation of the calculation of the value representative of the lifetime (DDV) and its non-volatile storage.

9. Circuit or method according to claim 8, wherein, in an operating zone, no update of the value representative of the remaining lifetime is performed.

10. Circuit or method according to any of claims 7 to 9, as dependent on claim 5, wherein an operating zone (II) further conditions the transmission (88) of a signal representative of a malfunction of the capacitor to the distant system (7).

11. Circuit or method according to claim 10, wherein a counter of the remaining lifetime is deleted by being positioned at zero.

12. Circuit according to any of claims 1, 3 to 11, or method according to any of claims 2 to 11, wherein the calculation of the value representative of the remaining lifetime (DDV) is performed at a frequency in the range from one second to one minute.

13. Circuit according to any of claims 1, 3 to 12, or method according to any of claims 2 to 12, wherein said points of the capacitor comprise points at the periphery and at the center of the component.

14. Circuit according to any of claims 1, 3 to 13, or method according to any of claims 2 to 13, wherein the temperature taken into account for the calculation of the remaining lifetime is equal to the average of the temperatures measured by the temperature sensors (57, 100) .

15. Circuit or method according to claim 14, wherein the temperature taken into account for the calculation of the remaining lifetime is equal to the maximum value among the temperatures measured by the temperature sensors (57, 100).

16. Circuit according to any of claims 1, 3 to 15, or method according to any of claims 2 to 15, wherein a remaining lifetime which is null or smaller than a threshold triggers the emission of a signal.

17. System comprising:

    an equipment (3);
    a component (1) associated with the equipment; and
    a circuit (5) according to any of claims 1, 3 to 16.

Fig 1

Fig 2

Fig 3

EP 4 073 528 B1

Fig 4

Fig 5

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 1914416
- WO 2013110027 A
- US 2015130380 A
- EP 3242138 A
- EP 1338874 A